# EUROPEAN PATENT APPLICATION

(11) **EP 1 018 761 A1**
(43) Date of publication of application: **12.07.2000**
(21) Application number: 98938929.1
(22) Date of filing: 21.08.1998
(51) Int. Cl.: H01L 21/60

(54) **SEMICONDUCTOR DEVICE AND METHOD OF FABRICATING THE SAME**

(30) Priority: 21.08.1997 JP 22477997; 25.06.1998 JP 17851198
(71) Applicant: Citizen Watch Co., Ltd., Tokyo 163-0428 (JP)
(72) Inventor: KIKUCHI, Masayoshi Citizen Watch Co., Ltd., Tokorozawa-shi Saitama 359-8511 (JP); TAGUCHI, Noboru Citizen Watch Co., Ltd., Tokorozawa-shi Saitama 359-8511 (JP); UEDA, Koichi Citizen Watch Co., Ltd., Tokorozawa-shi Saitama 359-8511 (JP); WATANABE, Makoto Citizen Watch Co., Ltd., Tokorozawa-shi Saitama 359-8511 (JP)
(74) Representative: Prüfer, Lutz H., Dipl.-Phys.
(86) International application number: JP9803709
(87) International publication number: WO9910928

(57) **Abstract**

An insulating film (3) having an opening (3a) over respective electrode pads (2) serving as a plurality of I /O terminals of a semiconductor chip (1a) is formed on a surface of the semiconductor chip (1a), and a plurality of connecting electrodes (4) is formed on the insulating film (3) so as to be in contact with the respective electrode pads (2) through the respective openings (3a). A thermoplastic resin (5) is formed on the respective connecting electrodes (4), and the respective thermoplastic resins (5) are caused to be attached with or to be contained with a plurality of pieces (preferably not less than ten pieces) of conductive particles (9), thereby making up a semiconductor device (1). When mounting the semiconductor device (1) on a substrate with wirings patterned thereon, placement of the semiconductor device (1) is decided upon such that the respective connecting electrodes (4) are positioned opposite to the predetermined wirings, and the semiconductor device (1) is pressed into contact with the substrate to which an insulating resin is applied before heating the same, thereby causing electrical connection to occur between the connecting electrodes (4) and the wirings by a plurality of conductive particles (9) pressed and sandwiched therebetween.

## Description

### TECHNICAL FIELD

The invention relates to a semiconductor device and a method of fabricating the same. More particularly, the invention is concerned with a semiconductor device mounted on a glass substrate of a liquid crystal display panel for use as a display unit of information equipment such as televisions, computers, and so forth by the chip-on-glass (COG) method, or a semiconductor device mounted by the chip-on-board (COB) method on a printed circuit board built in electronic equipment for performing control operation, and is also concerned with a method of fabricating the same.

### BACKGROUND TECHNOLOGY

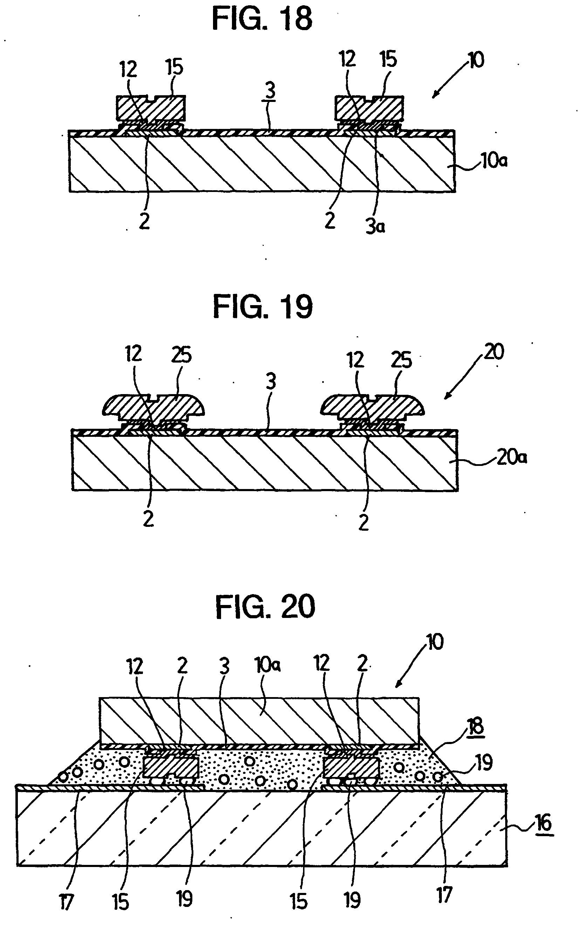

Taking an example of a semiconductor device mounted on a glass substrate of a liquid crystal display panel by the COG method with an anisotropic conductive film interposed therebetween, a conventional semiconductor device is described hereinafter with reference to Fig. 18 and 19.

Figs. 18 and 19 show a conventional semiconductor device, respectively, Fig. 18 being a sectional view of the conventional semiconductor device provided with straight wall bumps, and Fig. 19 a sectional view of the conventional semiconductor device provided with mushroom bumps.

Fig. 20 is a schematic sectional view showing a condition wherein the semiconductor device shown in Fig. 18 is mounted on the glass substrate of the liquid crystal display panel with the anisotropic conductive film interposed therebetween.

The semiconductor device 10 shown in Fig. 18 is provided with a multitude of electrode pads 2 (only two pieces thereof as enlarged are shown in the figure), made of aluminum, serving as I /O terminals, which are formed on a surface of a semiconductor chip 10a (shown in a simplified sectional view, however, a multitude of elements such as MOS transistors are in fact formed thereon). An insulating film 3 having an opening 3a over the respective electrode pads 2 is formed on the semiconductor chip 10a, and a plurality of the straight wall bumps 15 is provided at positions corresponding to the respective electrode pads 2 over the insulating film 3 through the intermediary of respective electrode films 12 kept in contact with the respective electrode pads 2 through the respective openings 3a.

For the electrode film 12, a film composed of at least two layers, one made of a metal for preventing mutual diffusion with the electrode pads 2 and gold which is a constituent material of the bumps 15, and the other made of a metal having a function of maintaining adhesion with the bumps 15, respectively.

As shown in Fig. 20 by way of example, the semiconductor device 10 is mounted on a glass substrate 16 of a liquid crystal display panel, provided with wirings 17 patterned thereon by use of indium tin oxide (ITO) in such a way as to sandwich therebetween an anisotropic conductive film 18 containing conductive particles 19 dispersed therein.

Hereupon, the bumps 15 is rendered electrically connecting with the wirings 17 by sandwiching the conductive particles 19 between the bumps 15 of the semiconductor device 10 and the wirings 17 formed on the glass substrate 16, and by applying heat and pressure thereto. Insulation between the bumps 15, adjacent to each other, can be maintained because the conductive particles 19 are not sandwiched therebetween.

The conductive particles 19 are made up of a laminated film composed of nickel (Ni) and gold (Au), formed on a surface of an organic polymer resin, and those having a diameter in the range of 5 µm to 10 µm are in use.

In Fig. 20, for the sake of convenience in illustration, two or three pieces of the conductive particles 19 are shown to be sandwiched between the respective bumps 15 and the respective wirings 17. However, in order to secure electrical conduction with resistance at not more than 1 Ω, at least about ten pieces of the conductive particles 19 needs to be sandwiched therebetween.

Accordingly, it has become evident based on test results that in the case wherein the conductive particles 19 are 5 µm in diameter, an upper surface area of the respective bumps 15 needs to be not less than 3000 µm².

Thus, since the respective bumps 15 need to have an upper surface area not less than 3000 µm², the respective bumps 15 were needed to be formed in size at 60 µm × 50 µm if the same were designed based on the assumption that the bumps 15 are arranged at an alignment pitch of 80 µm, and gap between the adjacent bumps 15 is set at 20 µm.

Further, the respective bumps 15 were designed to have a height (height of an upper surface of the respective bumps 15 from the surface of the insulating film 3) in the range between 10 µm and 20 µm, taking into consideration capability of the respective bumps 15 for efficiently arresting the conductive particles 19 over the top thereof, and the fact that a gap between the semiconductor device 10 and the glass substrate 16 is to be filled up with resin composing the anisotropic conductive film 18.

In the case where the bumps 15 were of a straight wall bump type and the conductive particles 19 were 5 µm in diameter, the alignment pitch (connection pitch) of the bumps 15 as small as 50 µm could be accommodated.

Meanwhile, as shown in Fig. 19, there is also available a semiconductor device 20 provided with the mushroom bumps 25.

The mushroom bumps 25 are made up of a laminated film composed of gold (Au) or copper (Cu) and gold (Au), and are formed by means of the plating. And as with the case of the straight wall bumps, the mushroom bumps 25 are electrically connected with respective electrode pads 2 of a semiconductor chip 20a via an electrode film 12.

In the case where the semiconductor device 20 having the mushroom bumps 25 was mounted on a substrate by use of the anisotropic conductive film in the same way as shown in Fig. 20, if the conductive particles 19 are 5 µm in diameter, a connection pitch less than 80 µm could not be accommodated because of a large diameter of the respective bumps 25.

As described above, there are available conventional semiconductors provided with either of two types of bumps, that is, either the straight wall bumps or the mushroom bumps, and since, in either case, the bumps are formed by means of the plating, variation in height thereof is likely to occur. For example, if the bumps are 15 µm in height, variation of a height in the order of 4 µm (± 2 µm) will occur. Consequently, variation tends to occur to an electrical connection condition between the bumps and the wirings as well, thereby unstabilizing electrical connection of the semiconductor device in a packaged state, and when a semiconductor device such as an IC for driving liquid crystals, and the like is mounted in a liquid crystal display panel, a problem has arisen that there will be no denying a possibility of faulty display occurring.

Now, superfine display is being required of a liquid crystal display unit to an increasing degree year after year, and with some liquid crystal display unit, a pixel pitch is required to be in the range of 20 µm to 40 µm in size.

However, if the conductive particles are less than 5 µm in diameter, the bumps of a semiconductor device, corresponding to the pixel pitch from 20 µm to 40 µm, can be designed. But if the conductive particles are 5 µm in diameter, it is impossible to mount the semiconductor device 10 so as to correspond to the pixel pitch as required such as from 20 µm to 40 µm because even in the case of the straight wall bumps 15, the connection pitch is 50 µm at the minimum.

As a result, there was no choice but to design an mounting area by widening the pixel pitch. If the pixel pitch is widened, a picture-frame size of a liquid crystal display unit had to be enlarged, causing a problem of depreciating a commercial value of the liquid crystal display unit of which miniaturization is required.

Further, in order to obtain the connection pitch of 20 µm so as to correspond to such a fine pixel pitch as 20 µm, the bumps need to be formed such that a width of respective openings in a resist is not more than 10 µm to a thickness of the resist in the range of 10 µm to 20 µm. As a result, a tight aspect ratio of the resist (ratio of the thickness to the width of the openings) is required, thus causing a problem of difficulty being encountered in stable formation of the resist

In particular, in the case of the mushroom bumps as shown in the semiconductor device in Fig. 19, the alignment pitch is 80 µm at the minimum, and accordingly, the connection pitch needs to be designed wider relative the pixel pitch than in the case of the straight wall bumps. In order to widen the connection pitch, a picture-frame size of portions of the liquid crystal display unit, outside display regions thereof, needs to be enlarged, thus resulting in further depreciation of the commercial value of the liquid crystal display unit than in the case of the semiconductor device provided with the straight wall bumps.

In the case of the mushroom bumps, it is practically impossible to form the bumps with a height in the range of 10 µm to 20 µm, corresponding to the connection pitch at 20 µm due to a structural feature of the mushroom bumps having a cap on top thereof.

The invention has been developed to solve such problems as described above encountered by the conventional semiconductor device, and an object of the invention is to provide a semiconductor device wherein electrical connection in a packaged state is ensured and stabilized while the connection pitch can be rendered sufficiently small, and also to provide a method of fabricating the semiconductor device.

### DISCLOSURE OF THE INVENTION

To this end, the invention provides a semiconductor device comprising an insulating film formed on a surface of a semiconductor chip, having an opening over respective electrode pads serving as a plurality of I /O terminals of the semiconductor chip, a plurality of connecting electrodes formed on the insulating film so as to be in contact with the respective electrode pads through the respective openings, and a thermoplastic resin formed on the respective connecting electrodes, a plurality of pieces of conductive particles being contained in the respective thermoplastic resin.

The respective connecting electrodes are preferably formed of a two-layer film made up of chromium, and copper, or a three-layer film made up of chromium, copper, and gold.

A method of fabricating a semiconductor device according to the invention comprises the following steps from (1) to (5):
(1) a step of forming an insulating film having an opening over respective electrode pads, serving as a plurality of I /O terminals of a semiconductor chip, on a surface of the semiconductor chip;
(2) a step of forming a metal film on the insulating film so as to be in contact with the respective electrode pads through the respective openings;
(3) a step of forming a photosensitive resin film having thermoplasticity substantially across a surface of the metal film, and forming masks at positions corresponding to the respective electrode pads by the photolithography;
(4) a step of removing portions of the metal film, not covered by the masks of the photosensitive resins by etching, and forming a connecting electrode in contact with the respective electrode pads in respective portions of the metal film, covered by the masks; and
(5) a step of attaching conductive particles to the respective photosensitive resins.

In the step (3) described above, a photosensitive resin film having thermoplasticity and containing conductive particles may be formed substantially across a surface of the metal film.

Thereupon, when, in the step (4), the portions of the metal film, not covered by the masks of the photosensitive resin film, are removed by etching, and the connecting electrode in contact with the respective electrode pads is formed in the respective portions of the metal film, covered by the masks, the photosensitive resin film having thermoplasticity and containing conductive particles is left intact on top of the respective connecting electrodes.

Consequently, the above-mentioned step (5) of attaching the conductive particles to the photosensitive resins becomes unnecessary.

With reference to the above-mentioned methods of fabricating the semiconductor device according to the invention, in the step of forming the metal film, a two-layer film composed of chromium and copper, or a three-layer film composed of chromium, copper, and gold is preferably formed by the sputtering across a surface of the semiconductor chip with the insulating film formed thereon.

Otherwise, after forming the insulating film on the surface of the semiconductor chip in the above-mentioned step (1), a plurality of connecting electrodes in contact with the respective electrode pads through the respective openings, having a surface area larger than the respective openings, may be formed on the insulating film by electroless plating, a thermoplastic resin may be formed on top of the respective connecting electrodes, and the conductive particles may be attached to the respective thermoplastic resins.

Or by forming the thermoplastic resins containing the conductive particles on top of the respective connecting electrodes formed by the electroless plating, the step of attaching the conductive particles to the respective thermoplastic resins becomes unnecessary.

### BRIEF DESCRIPTION OF THE DRAWINGS

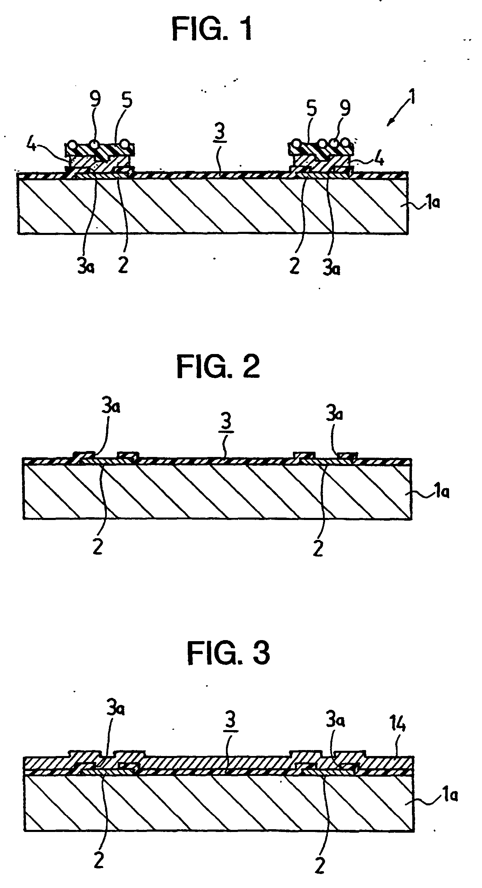

Fig. 1 is a schematic sectional view showing an embodiment of a semiconductor device according to the invention;
Figs. 2 to 7 are schematic sectional views showing respective steps in sequence for illustrating a first embodiment of a method of fabricating the semiconductor device, according to the invention;

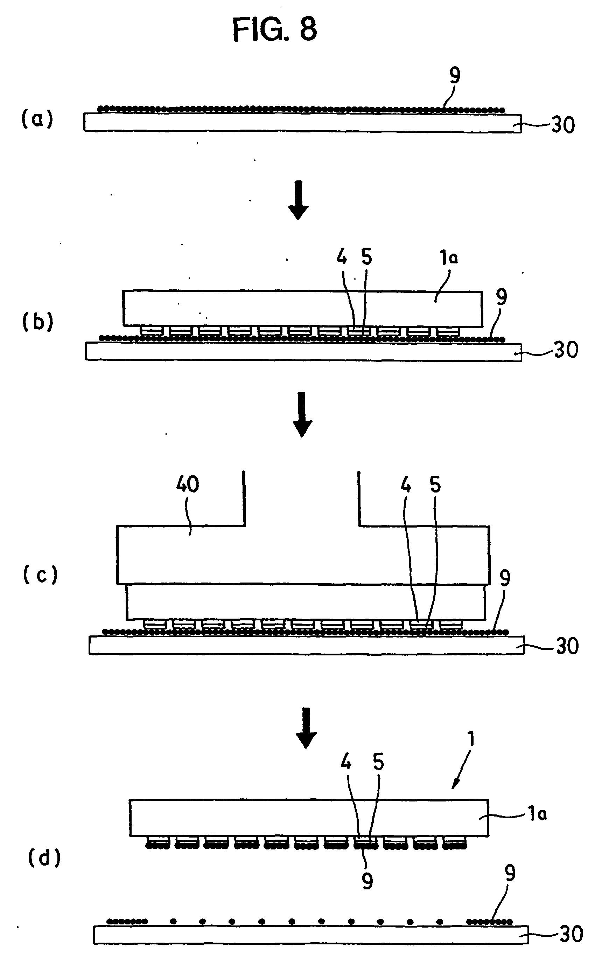

Fig. 8 is a process drawing showing a step of attaching conductive particles to a photosensitive resin provided on top of respective connecting electrodes of the semiconductor device provided with a multitude of the connecting electrodes provided in a row thereon;

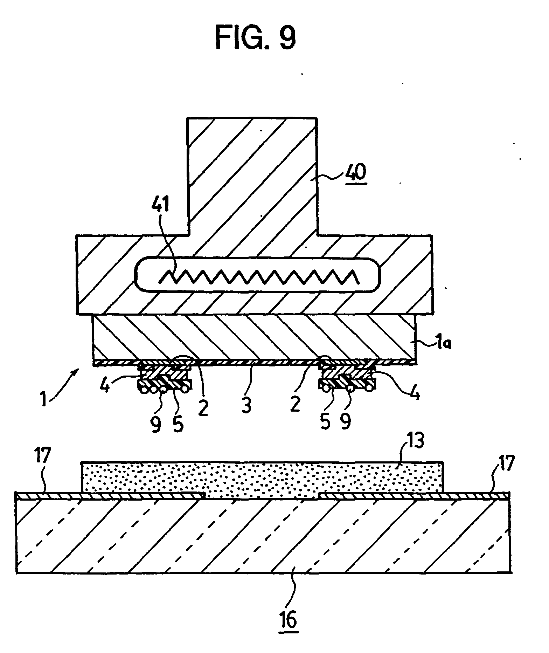

Fig. 9 is a schematic sectional view showing an initial step of mounting the semiconductor device shown in Fig. 1 onto a glass substrate of a liquid crystal display panel;

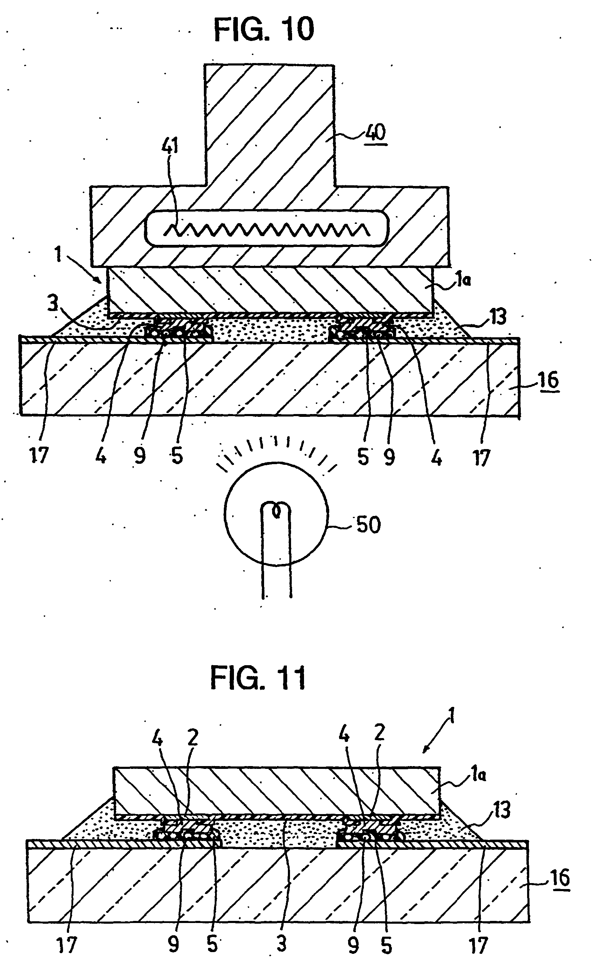

Fig. 10 is a schematic sectional view showing a step of pressing and heating when mounting the semiconductor device shown in Fig. 1 onto the glass substrate;
Fig. 11 is a schematic sectional view showing a condition wherein mounting of the semiconductor device shown in Fig. 1 is completed;

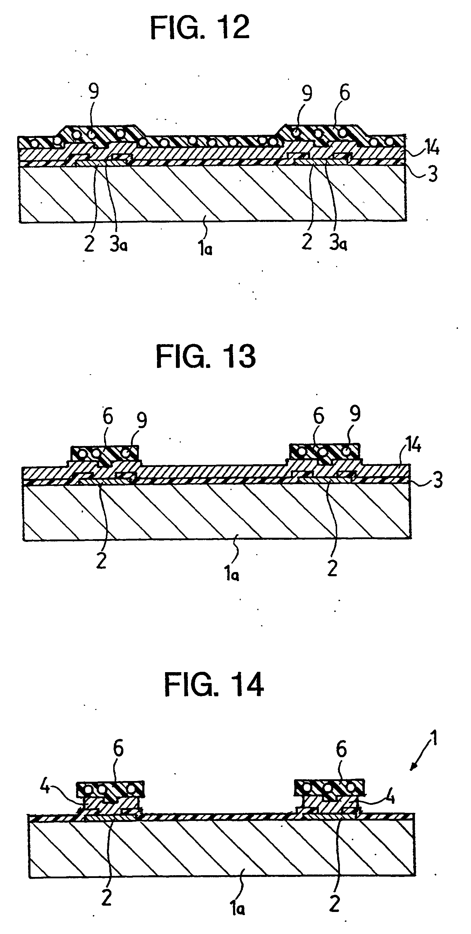

Figs. 12 to 14 are schematic sectional views showing respective steps in sequence which differ from those of the first embodiment of the method of fabricating the semiconductor device for illustrating a second embodiment of a method of fabricating the semiconductor device according to the invention;

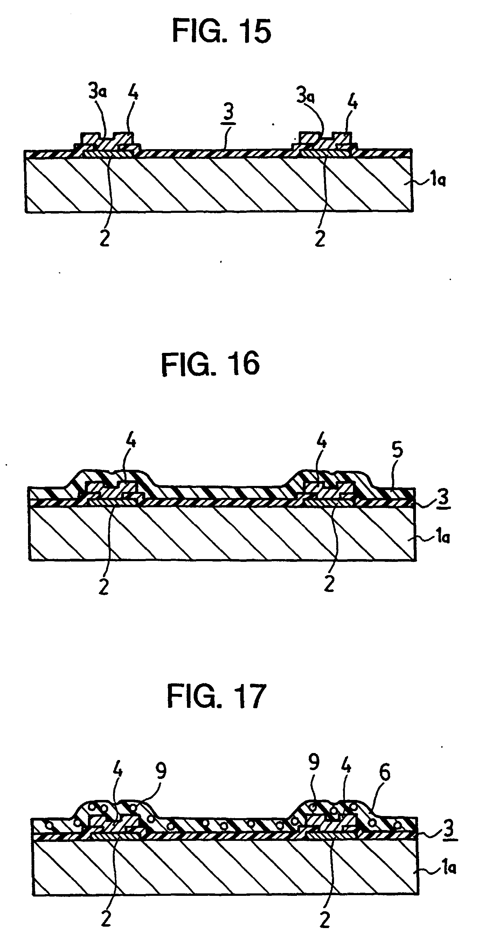

Figs. 15 to 17 are schematic sectional views showing intermediate steps for illustrating third and fourth embodiments of a method of fabricating the semiconductor device, according to the invention;
Figs. 18 and 19 are schematic sectional views, each showing a different example of a conventional semiconductor device; and
Fig. 20 is a schematic sectional view showing a packaged structure of the conventional semiconductor device shown in Fig. 18 when mounted on a glass substrate of a liquid crystal display panel.

### BEST MODE FOR CARRYING OUT THE INVENTION

Preferred embodiments of a semiconductor device and a method of fabricating the same, according to the invention, are described hereinafter with reference to the accompanying drawings.

### Construction of a Semiconductor Device: Fig. 1

First, an embodiment of the semiconductor device according to the invention is described with reference to Fig. 1. In Fig. 1, parts corresponding to those in Fig. 18 are denoted by the same reference numerals.

The semiconductor device 1 shown in Fig. 1 is provided with a multitude of electrode pads 2 (only two pieces thereof are shown in enlarged form in the figure) serving as I /O terminals, which are formed on a surface of a semiconductor chip 1a (shown in a simplified sectional view, however, a multitude of elements such as MOS transistors are in fact formed thereon).

An insulating film 3 is formed so as to cover a surface of the semiconductor chip 1a, and is provided with an opening 3a over the respective electrode pads 2.

A plurality of connecting electrodes 4 is provided at positions corresponding to the respective electrode pads 2 over the insulating film 3 so as to be in contact with the respective electrode pads 2 through the respective openings 3a, and the respective connecting electrodes 4 are provided with a resin 5 having thermoplasticity, formed thereon. A plurality of pieces (preferably, not less than ten pieces) of conductive particles 9 (beads) is attached to or contained in an upper surface of the respective resins 5.

The insulating film 3 is formed of a silicon nitride (SiN) film with a thickness in the range of 0.2 µm to 3 µm. Besides the silicon nitride (SiN) film, as an inorganic film, for example, a silicon oxide film containing impurities, such as a phosphoric silicate glass (PSG), or a polyimide film which is an organic film may be used. Also, a two-layer structure composed of a combination of the inorganic film as represented by the silicon nitride (SiN) film, and the organic film may be used instead.

The respective connecting electrodes 4 are preferably formed of a single-layer metal film of gold (Au), silver (Ag), copper (Cu), and so forth, a laminated metal film composed of two layers, made of chromium (Cr) and copper (Cu), or a three-layer film made up of chromium (Cr), copper (Cu) and gold (Au). Otherwise, a two-layer film made up of titanium (Ti)-tungsten (W) alloy and gold (Au) may be used instead.

The connecting electrode 4 is formed to a thickness in the range of 0.5 µm to 5 µm. If the connecting electrode 4 is formed to a thickness in excess of 5 µm, this is not desirable because not only time required for forming the same by the sputtering described hereinafter will be lengthened, but also time required for etching the metal film to form the connecting electrode 4 will be lengthened. Furthermore, this is not desirable also from the viewpoint of difficulty with obtaining good etching characteristics because a sidewall at opposite ends of the connecting electrode 4 tend to be in a tapered shape.

For the resin 5 having thermoplasticity, formed on top of the connecting electrode 4, a photosensitive resin is used in view of a method of fabricating the same as adopted, and a rubber base resist or a diazide base resist for example, THB manufactured by JSR, OMR 83 (negative resist) or OFPR 800 (positive resist) manufactured by TOKYO OHKA KOGYO CO., LTD. or the like is used.

However, if the photolithography is not employed when fabricating the same, there is no need for using the photosensitive resin, and use of a thermoplastic resin may suffice.

It is desirable that the respective resins 5 are formed to a thickness ranging from one third to three times a diameter of the conductive particles 9 so as to enable the same to have a function of holding the conductive particles 9 to be attached thereto in the manner described later.

In particular, if the respective resins 5 have a thickness more than three times the diameter of the conductive particles 9, there arises a possibility that the shape of the respective resins 5 will collapse and the resins 5 will spread out on both sides thereof during a process of attaching the conductive particles 9 thereto in the manner as described later, thereby raising a risk of a gap between the respective connecting electrodes 4, adjacent to each other, being filled up with the resins 5. In such a case, the gap between the respective connecting electrodes 4, adjacent to each other can not be filled up with an insulating resin (adhesive) when mounting the semiconductor device 1 on a substrate through the intermediary of the insulating resin as described later, representing an undesirable case from the viewpoint of reliability in respect of a packaged structure.

The conductive particles 9 are spherical particles ranging from 1 µm to 15 µm in diameter, however, the diameter thereof may be not more than 5 µm. The conductive particles 9 are made up of a core made of a polymer resin with a laminated film composed of nickel (Ni) and gold (Au), formed on the surface of the core. However, a composition of the conductive particles 9 is not limited to the above-mentioned, and simple metal particles and alloy particles, composed of nickel (Ni), palladium (Pd) / tin (Sn), gold (Au), silver (Ag), copper (Cu), and so forth, may be used instead.

Thus, since the semiconductor device 1 is provided with the resin 5 having thermoplasticity formed on top of the respective connecting electrodes 4, direct contact of the respective connecting electrodes 4 with air can be prevented. Consequently, this enables use of a metal relatively susceptible to oxidation such as silver (Ag), copper (Cu), and so forth on the surface of the respective connecting electrodes 4, thereby enabling cost of fabrication to be reduced.

Further, as the conductive particles 9 are provided on top of the respective connecting electrodes 4 by attaching the former onto the respective thermoplastic resins 5, a multitude of the conductive particles 9 can be brought into contact with wirings only at the locations where the respective connecting electrodes 4 exist when the semiconductor device 1 is mounted on the substrate by press-bonding the former with the latter. As a result, electrical connection when the semiconductor device 1 is mounted can be maintained in an excellent condition.

In addition, uniformity in the height of the respective connecting electrodes 4 can be improved by forming the same with the use of the sputtering or the vacuum evaporation, and consequently, a condition of connection with the wirings will become highly uniform. As a result, in the case where the semiconductor device 1 is mounted on a glass substrate of a liquid crystal display panel, excellent display performance can be ensured.

Further, since the semiconductor device 1 is constructed such that the conductive particles 9 are not present in any part thereof other than the connecting electrodes 4, insulation characteristics are improved if thermosetting resin, thermoplastic resin, or optosetting resin is used for the insulating resin (adhesive) at the time of mounting the semiconductor device 1.

Also, since the conductive particles 9 are provided over the respective connecting electrodes 4 only, and none of the conductive particles 9 is sandwiched between the respective connecting electrodes 4, adjacent to each other, electrical insulation between the respective connecting electrodes 4 can be enhanced. Accordingly, excellent insulation can be maintained even if spacing between the respective connecting electrodes 4 is narrowed down, and consequently, electrical connection at a connection pitch finer than for the conventional case can be attained.

For example, in the case where the semiconductor device 1 is mounted on a glass substrate of a liquid crystal display panel, the connection pitch in the range of 20 µm to 40 µm can be accommodated.

Since the conductive particles 9 may be not more than 5 µm in diameter, smaller than the conventional ones, a surface area of the respective connecting electrodes 4 can be reduced to that extent This contributes to implementation of connection at a connection pitch corresponding to a fine pixel pitch of a liquid crystal display panel. First Embodiment of a Fabrication Method: Figs. 1 to 8

A method of fabricating the semiconductor device 1 shown in Fig. 1 is described hereinafter as a first embodiment of a method of fabricating a semiconductor device according to the invention.

Figs. 2 to 7 are schematic sectional views showing steps of the method of fabricating the same in sequence, and Fig. 1 shows the semiconductor device which has been completed by the method.

As shown in Fig. 2, an insulating film 3 having an opening 3a over respective electrode pads 2 is first formed to a thickness in the range of 0.5 µm to 5 µm on a surface of a semiconductor chip 1a provided with a plurality of the electrode pads 2 formed thereon.

The insulating film 3 is formed of a silicon nitride (SiN) film across the surface of the semiconductor chip 1a by the plasma chemical vapor deposition (CVD). Thereafter, a photosensitive resin is applied to a surface of the SiN film, openings are formed in portions of the photosensitive resin, corresponding to the respective electrode pads 2, by use of the photolithography, and the SiN film is etched using the photosensitive resin as masks, thereby forming openings 3a.

Next, as shown in Fig. 3, a metal film 14 is formed to a substantially uniform thickness in the range of 0.5 µm to 10 µm across an upper surface of the insulating film 3 on the semiconductor chip 1a by use of the sputtering or the vacuum evaporation. The metal film 14 is formed of any of a single-layer metal film and a multiple-layer metal film, preferably a two-layer film composed of chromium and copper, a three-layer film composed of chromium, copper, and gold, or a two-layer film composed of a titanium-tungsten alloy and gold.

The metal film 14 is in contact with the respective electrode pads 2 through the respective openings 3a of the insulating film 3. The metal film 14 is formed of a metal film having good intimate contact with the electrode pads 2 made of aluminum for underlayer, and is formed of a metal film having a high electric conductivity for upper layer.

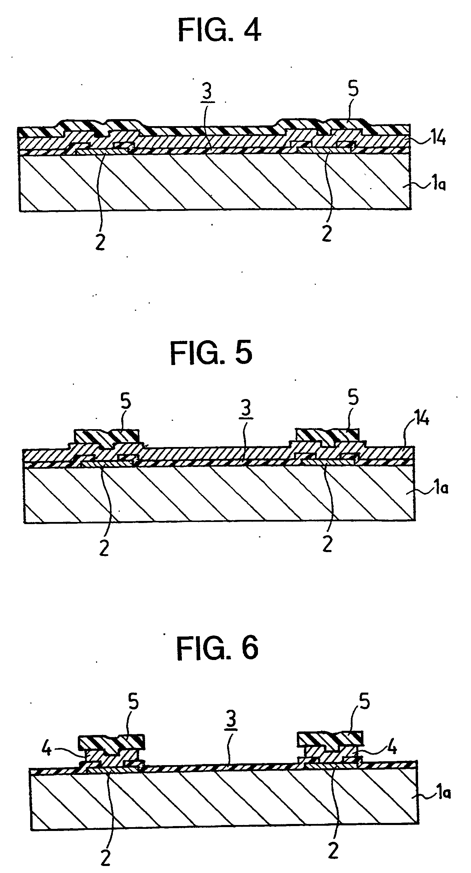

Subsequently, as shown in Fig. 4, a film of a photosensitive resin 5 having thermoplasticity is formed across a surface of the metal film 14. Thereafter, as shown in Fig. 5, patterning of the photosensitive resin 5 is performed by use of the photolithography whereby exposure and development processes are applied to the photosensitive resin 5 such that masks having a surface area larger than the respective openings 3a of the insulating film 3 are formed at portions thereof, corresponding to the respective electrode pads 2.

In this connection, in the case of wet-etching the metal film 14 when respective portions of the photosensitive resin 5, left intact as the masks, have a surface area, which is the same as or smaller than the size of the respective openings 3a of the insulating film 3, there is a possibility that a portion of the respective electrode pads 2 will be etched at the same time when the metal film 14 is etched as described later. Accordingly, the photosensitive resin 5 is patterned in such a shape as to overlap the respective openings 3a to the extent of not less than 2 µm from the periphery thereof.

In the case of patterning the metal film 14 by dry-etching, the respective portions of the photosensitive resin 5, left intact as the masks, can be rendered to have a surface area equivalent to or smaller than the size of the respective openings 3a of the insulating film 3 provided that an etch selectivity between the metal film 14 and the electrode pads 2 is increased.

Subsequently, by etching the metal film 14 using the respective portions of the photosensitive resin 5, left intact as the masks, and by removing portions of the metal film 14, not covered by the photosensitive resin 5, a connecting electrode 4 is formed in respective portions of the metal film 14, covered by the photosensitive resin 5, as shown in Fig. 6. Even after completion of this etching process, the portions of the photosensitive resin 5, left intact, are not removed.

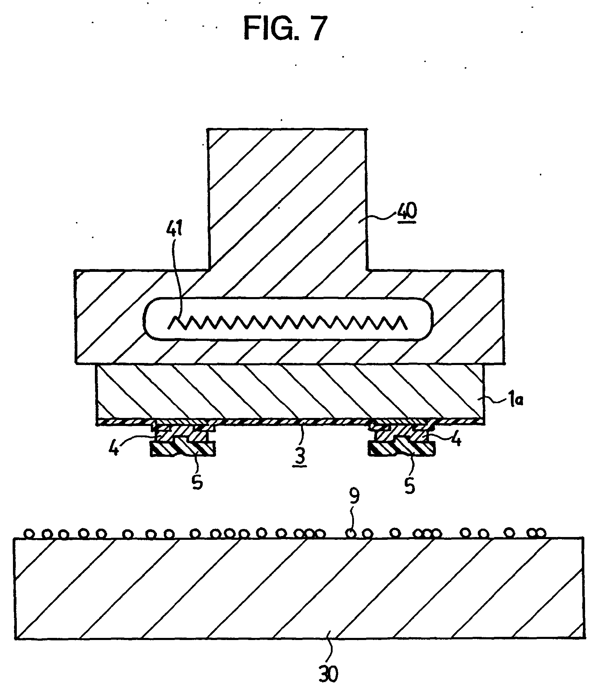

Then, as shown in Fig. 7, a fiat plate 30 with a multitude of conductive particles 9 placed on a surface thereof at a high density is prepared. Meanwhile, the semiconductor chip 1a shown in Fig. 6 is fixedly attached to the underside surface of a press heating tool 40 incorporating a heater 41 therein such that a surface of the semiconductor chip 1a with the photosensitive resins 5 formed thereon points downward. Hereupon, the semiconductor chip 1a is fixed to the press heating tool 40 by vacuum holding. Subsequently, the press heating tool 40 is caused to descend, thereby pressing the photosensitive resins 5 side of the semiconductor chip 1a against the flat plate 30.

Thereupon, a thermoplastic photosensitive resins 5 are softened to some extent by heat applied by the heater 41 inside the press heating tool 40, so that the multitude of the conductive particles 9 placed on the flat plate 30 can be attached to the photosensitive resins 5. The flat plate 30 is then loses the number of the conductive particles 9 thereof to the extent that have been attached to the photosensitive resins 5. After completion of this step of processing, the semiconductor device 1 provided with the plurality of the conductive particles 9 attached to the photosensitive resins 5 on top of the respective connecting electrodes 4 as shown in Fig. 1 is completed.

In the step of attaching the conductive particles 9 as described above, an effective load for pressing is set in the range of 1 kg to 5 kg, heating temperature at 100°C, and a duration for heating in the range of 5 seconds to 10 seconds.

It is desirable tat the conductive particles 9 placed on the flat plate 30 are caused to be attached to the photosensitive resins 5 at a high density, and that a density at which the conductive particles 9 are placed on the flat plate 30 satisfies at least a relationship S1 >S2 × 10 provided that a surface area of the respective connecting electrodes 4 is defined S1, and a surface area of the conductive particles 9 after press-bonded as seen by projecting the same in the direction of press-bonding is defined S2.

With this embodiment, since the metal film 14 is formed by use of the sputtering or the vacuum evaporation, and the respective connecting electrodes 4 are formed by etching the former, variation in a height thereof (film thickness) fails within 0.5 µm, and consequently, substantially uniform connecting electrodes with very small variation in thickness can be obtained.

Furthermore, this embodiment wherein a plating process as required in the conventional case is not necessary has also an advantage of shortening a fabrication process.

In an example described above, two pieces each of the connecting electrodes 4 and the photosensitive resins 5 with the conductive particles 9 attached thereto are provided on the semiconductor chip 1a for the sake of convenience in illustration, however, in practical applications, a multitude of the connecting electrodes are installed on the semiconductor chip. Fig. 8 shows in detail a step of attaching the conductive particles 9 to the respective photosensitive resins 5 in such a case. In Fig. 8, parts corresponding to those in Fig. 7 are denoted by the same reference numerals.

In Fig. 8, (a) shows a flat plate 30 provided with a multitude of the conductive particles 9 placed thereon in a compact manner, and (b) shows a condition wherein a surface of a semiconductor chip 1a, on the photosensitive resins 5 side thereof, where the connecting electrodes 4 and the photosensitive resins 5 are formed, is butted against tile conductive particles 9 placed on the flat plate 30.

And, (c) shows a condition wherein the semiconductor chip 1a is being pressed and heated by the press heating tool 40.

And, (d) shows a condition wherein a multitude of the conductive particles 9 are caused to be attached to the respective photosensitive resins 5 after the semiconductor chip 1a is detached from the flat plate 30, thereby completing the semiconductor device 1.

### Method of Mounting the Semiconductor Device: Figs. 9 to 11

Next, a method of mounting the semiconductor device shown in Fig. 1, fabricated by the method of fabrication as described in the foregoing, on a glass substrate of a liquid crystal display panel will be described hereinafter.

As shown in Fig. 9, an insulating resin (adhesive) 13 serving as a sealant is applied with the use of a dispenser to an area on a glass substrate 16 of the liquid crystal display panel, with wirings 17 patterned thereon, where the semiconductor device 1 is to be mounted. Subsequently, the wirings 17 are aligned with the connecting electrodes 4 of the semiconductor device 1, and pressure and heat are applied from the rear surface side of the semiconductor device 1 by the press heating tool 40, thereby curing the insulating resin 13.

As shown in Fig. 10, when heat and pressure are applied from the rear surface side of the semiconductor device 1 by the press heating tool 40, the photosensitive resins 5 on the respective connecting electrodes 4 are softened, so that the respective conductive particles 9 are sandwiched between the respective connecting electrodes 4 and the respective wirings 17 in such a way so as to be in contact with both. Thereupon, the respective conductive particles 9 sandwiched in-between causes electrical conduction to occur between the respective connecting electrodes 4 and the respective wirings 17, however, the conductive particles 9 which are not sandwiched therebetween maintain insulation by the photosensitive resin 5 and the insulating resin 13.

When using the insulating resin 13 formed in a sheet-like shape, the insulating resin 13 is disposed on the glass substrate 16 by press-bonding the same thereto with the use of the press heating tool.

When using thermosetting resin or thermoplastic resin for the insulating resin 13, a light source lamp 50 shown in Fig. 10 is unnecessary, however, when using optosetting resin, the insulating resin 13 needs to be cured by irradiating the same with light by lighting up the light source lamp 50 disposed on a side of the glass substrate 16, opposite from the semiconductor device 1 while keeping the semiconductor device 1 in a pressurized condition.

Fig. 11 shows a condition wherein the semiconductor device 1 is mounted on the glass substrate 16 in such a way as described above (that is, a packaged structure).

In this packaged condition, the respective connecting electrodes 4 of the semiconductor device 1 and the respective wirings 17 on the glass substrate 16 are in contact with each other through the intermediary of the conductive particles 9 contained in the respective photosensitive resins 5, and consequently, are electrically connected with each other. However, the connecting electrodes 4, adjacent to each other, are insulated from each other since electrical connection through the intermediary of the conductive particles 9 does not occur therebetween.

The conductive particles 9 sandwiched between the respective connecting electrodes 4 and the respective wirings 17 undergo deformation to the extent of 5 to 50 % thereof, and by curing the insulating resin 13 while keeping the conductive particles 9 in such a deformed condition, a connection condition described above is maintained, so that excellent electrical connection can be maintained.

The same applies not only to a case of mounting the semiconductor device 1 on a glass substrate of a liquid crystal display panel but also to a case wherein the semiconductor device 1 is mounted on a printed circuit board incorporated in various electronic equipment.

### Second Embodiment of a Fabrication Method: Figs. 12 to 14

Next, a second embodiment of a method of fabricating a semiconductor device, according to the invention, is described hereinafter with reference to Figs. 12 to 14.

The second embodiment of the invention, up to steps of forming an insulating film 3 and a metal film 14 on a surface of a semiconductor chip 1a with electrode pads 2 provided thereon, is the same as the first embodiment as described with reference to Figs. 2 and 3.

As shown in Fig. 12, in the case of the second embodiment, thermoplastic and photosensitive resin 6 with a multitude of conductive particles 9 mixed therein is applied to the metal film 14 formed across a surface of the semiconductor chip 1a, thereby forming a photosensitive resin film.

Thereafter, as shown in Fig. 13, patterning of the photosensitive resin 6 is performed by use of the photolithography as with the case of the first embodiment such that masks having a surface area larger than those of respective openings 3a of the insulating film 3 are formed at portions thereof, corresponding to the respective electrode pads 2 on the semiconductor chip 1a.

Subsequently, as shown in Fig. 14, by etching the metal film 14 using remaining portions of the photosensitive resin 6 as the masks, connecting electrodes 4 are formed over the respective electrode pads 2.

Thus, the semiconductor device 1 with the photosensitive resin 6 containing the conductive particles 9, provided on top of the respective connecting electrode 4, is completed. Consequently, with this embodiment, the step of attaching the conductive particles 9 to the respective photosensitive resins 5 as required in the first embodiment becomes unnecessary.

### Third and Fourth Embodiments of a Fabrication Method: Figs. 15 to 17

With the first and second embodiments of the method of fabricating the semiconductor device according to the invention, described hereinbefore, the insulating film 3 is formed on the surface of the semiconductor chip 1a provided with the electrode pads 2 formed thereon by use of the sputtering or the vacuum evaporation. In contrast, with third and fourth embodiments of the invention, a connecting electrode 4 made up of a metal film, composed of two layers or three layers, is formed only over the respective electrode pads 2 by electroless plating as shown in Fig. 15.

To this end, a photosensitive resin film is formed across a surface of a semiconductor chip 1a, provided with an insulating film 3 formed thereon. and by applying exposure and development processes to the photosensitive resin film, an opening is formed at positions thereof, corresponding to the respective electrode pads 2. Subsequently, electroless plating by use of, for example, nickel (Ni) is applied using remaining portions of the photosensitive resin film as masks, thereby forming a nickel film within the respective openings only, and further, by applying gold (Au) electroless plating, a metal film is formed on top of the respective nickel films, so that the connecting electrodes 4, each made up of a two-layer metal film, are formed. Thereafter, upon removal of the remaining portions of the photosensitive resin used as the masks, the semiconductor chip 1a will be in a condition as shown in Fig. 15.

With the third embodiment of the invention. as shown in Fig. 16, a film of photosensitive resin 5 having thermoplasticity is formed across a surface of the semiconductor chip 1a, provided with the connecting electrode 4 formed on the respective electrode pads 2 as described above, and patterning of the photosensitive resin 5 is performed by applying exposure and development processes thereto such that portions of the photosensitive resin 5, only over the respective connecting electrodes 4, are left intact, and by attaching conductive particles 9 to respective remaining portions of the photosensitive resin 5 as with the case of the first embodiment, the same semiconductor device as that shown in Fig. 1 is completed.

With the fourth embodiment of the invention, as shown in Fig. 17, a film of photosensitive resin 6 having thermoplasticity and containing conductive particles 9 mixed therein is formed across a surface of the semiconductor chip 1a, provided with a connecting electrode 4 formed on respective electrode pads 2 as shown in Fig. 15, and patterning of the photosensitive resin 6 is performed by applying exposure and development processes thereto such that portions of the photosensitive resin 6 with the conductive particles 9 mixed therein, only over the respective connecting electrodes 4, are left intact. As a result, the same semiconductor device as that shown in Fig. 14 is completed.

Similarly to the semiconductor device described hereinbefore, the semiconductor device fabricated in this way can also be securely mounted on a glass substrate or a printed circuit board through the intermediary of an insulating resin (adhesive).

### INDUSTRIAL APPLICABILITY

As is evident from the foregoing description, according to the invention, the connecting electrodes, each made up of the metal film having a very high uniformity in height in comparison with the bumps of the conventional semiconductor device, are provided, and the thermoplastic resin containing the conductive particles mixed therein is provided on top of the respective connecting electrodes, so that the conductive particles can be provided beforehand at a high density only at spots where electrical connection is required. Accordingly, the conductive particles not more than 5 µm in diameter can be used. Consequently, when mounting the semiconductor device according to the invention on, for example, a glass substrate of a liquid crystal display panel, it becomes possible to implement a packaged structure with a fine connection pitch at less than 40 µm.

Further, when the semiconductor device is attached to a substrate by thermal press bonding, the conductive particles can be prevented from spilling out because the respective connecting electrodes are formed of the metal film which can be held low in height unlike the case of the conventional bumps, so that conductive beads can be effectively arrested over the respective connecting electrodes.

Hence, the semiconductor device according to the invention is effective for use as vanous types of semiconductor devices such as ICs for driving a liquid crystal display panel, ICs, LSIs, etc. mounted on a printed circuit board of various electronic equipment, gate arrays, and so forth.

## Claims

1. A semiconductor device comprising:
an insulating film formed on a surface of a semiconductor chip, having an opening over respective electrode pads serving as a plurality of I /O terminals of the semiconductor chip;
a plurality of connecting electrodes formed on the insulating film so as to be in contact with the respective electrode pads through the respective openings; and
a thermoplastic resin formed on the respective connecting electrodes,
wherein a plurality of pieces of conductive particles are contained in the respective thermoplastic resins.

2. A semiconductor device according to claim 1, wherein the respective connecting electrodes are formed of a two-layer film made up of chromium, and copper.

3. A semiconductor device according to claim 1, wherein the respective connecting electrodes are formed of a three-layer film made up of chromium, copper, and gold.

4. A method of fabricating a semiconductor device, comprising the steps of:
forming an insulating film having an opening over respective electrode pads, serving as a plurality of I /O terminals of a semiconductor chip, on a surface of the semiconductor chip;
forming a metal film on the insulating film so as to be in contact with the respective electrode pads through the respective openings;
forming a photosensitive resin film having thermoplasticity substantially across a surface of the metal film, and forming masks at positions corresponding to the respective electrode pads by the photolithography;
removing portions of the metal film, not covered by the masks of the photosensitive resin by etching, and forming a connecting electrode in contact with the respective electrode pads in respective portions of the metal film, covered by the masks; and
attaching conductive particles to the respective photosensitive resins.

5. A method of fabricating a semiconductor device according to claim 4, wherein, in the step of forming the metal film, a two-layer film composed of chromium and copper, or a three-layer film composed of chromium, copper, and gold is formed by the sputtering or the vacuum evaporation across a surface of the semiconductor chip with the insulating film formed thereon.

6. A method of fabricating a semiconductor device, comprising the steps of:
forming an insulating film having an opening over respective electrode pads, serving as a plurality of I /O terminals of a semiconductor chip, on a surface of the semiconductor chip;
forming a metal film on the insulating film so as to be in contact with the respective electrode pads trough the respective openings;
forming a photosensitive resin film having thermoplasticity and containing conductive particles substantially across a surface of the metal film, and forming masks at positions corresponding to the respective electrode pads by the photolithography; and
removing portions of the metal film, not covered by the masks of the photosensitive resin by etching, and forming a connecting electrode in contact with the respective electrode pads in respective portions of the metal film, covered by the masks.

7. A method of fabricating a semiconductor device according to claim 6, wherein, in the step of forming the metal film, a two-layer film composed of chromium and copper, or a three-layer film composed of chromium, copper, and gold is formed by the sputtering or the vacuum evaporation across a surface of the semiconductor chip with the insulating film formed thereon.

8. A method of fabricating a semiconductor device, comprising the steps of:
forming an insulating film having an opening over respective electrode pads, serving as a plurality of I /O terminals of a semiconductor chip, on a surface of the semiconductor chip;
forming a plurality of connecting electrodes in contact with the respective electrode pads through the respective openings on the insulating film by electroless plating;
forming a thermoplastic resin on top of the respective connecting electrodes; and
attaching conductive particles to the respective thermoplastic resin.

9. A method of fabricating a semiconductor device, comprising the steps of:
forming an insulating film having an opening over respective electrode pads, serving as a plurality of I /O terminals of a semiconductor chip, on a surface of the semiconductor chip;
forming a plurality of connecting electrodes in contact with the respective electrode pads through the respective openings, having a surface area larger than the respective openings, on the insulating film by electroless plating; and
forming a thermoplastic resin, containing conductive particles, on top of the respective connecting electrodes.
